(19) **Europäisches Patentamt European Patent Office Office européen des brevets**

(11) **EP 4 199 120 B1**

(12) **EUROPEAN PATENT SPECIFICATION**

(45) Date of publication and mention
of the grant of the patent:
**26.03.2025  Bulletin 2025/13**

(21) Application number: **21214596.5**

(22) Date of filing: **15.12.2021**

(51) International Patent Classification (IPC):
*H01L 31/042* (2014.01)        *H02S 40/42* (2014.01)
*H02S 20/00* (2014.01)

(52) Cooperative Patent Classification (CPC):
**H10F 19/00; H02S 20/00; H02S 40/425;**
**Y02E 10/50**

(54) **SYSTEM COMPRISING PHOTOVOLTAIC MODULES WITH MULTIPLE VANES AND CORRESPONDING ARRANGING METHOD**

SYSTEM MIT PHOTOVOLTAISCHEN MODULEN MIT MEHREREN FLÜGELN UND ENTSPRECHENDES ANORDNUNGSVERFAHREN

SYSTÈME COMPRENANT DES MODULES PHOTOVOLTAÏQUES AVEC DE MULTIPLES AUBES ET PROCÉDÉ D'AGENCEMENT CORRESPONDANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.06.2023  Bulletin 2023/25**

(73) Proprietors:
• **Imec VZW**
  **3001 Leuven (BE)**
• **Kuwait University**
  **05969 Safat (KW)**
• **Katholieke Universiteit Leuven**
  **3000 Leuven (BE)**

(72) Inventors:
• **Bourisli, Raed I H M**
  **73302 Rawda (KW)**

• **Aldalali, Bader S H M**
  **13122 Safat (KW)**
• **Tuomiranta, Arttu**
  **3500 Hasselt (BE)**
• **Chowdhury, Mohammed Gofran**
  **2800 Mechelen (BE)**
• **Poortmans, Jef**
  **3010 Kessel-Lo (BE)**

(74) Representative: **Körfer, Thomas et al**
**Mitscherlich PartmbB**
**Patent- und Rechtsanwälte**
**Karlstraße 7**
**80333 München (DE)**

(56) References cited:
**EP-B1- 2 362 161          US-A- 6 061 978**
**US-A1- 2005 263 181     US-A1- 2010 126 554**
**US-A1- 2014 299 178**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to a system comprising at least two photovoltaic modules, wherein the system and/or at least one of the at least two photovoltaic modules comprises multiple vanes, especially for trapping and/or guiding wind to the corresponding photovoltaic module or the system, respectively, and a corresponding method for arranging said at least two photovoltaic modules.

Generally, in times of an increasing importance of renewable energy generation, especially photovoltaic power plants, there is a growing need of reducing the temperature of respective photovoltaic modules because high photovoltaic module temperatures reduce their efficiency. One reason for the high module temperature is the actual geometry of the module which makes releasing energy to its surroundings rather difficult. Heat typically builds up on the frontside and/or the backside of the photovoltaic module, i.e., the wake region, where low wind velocities are normally experienced and where heat is usually trapped.

JP 2013-093377 A relates to a photovoltaic power generation panel comprising a panel body in the shape of a plurality of louvers arranged vertically while spaced apart vertically by a passage; a straightening plate provided on the upper side of the panel body located at the uppermost part; and an outlet provided in the straightening plate and discharging air from the rear of the panel so as to be distributed along the panel surface of the panel body located at the uppermost part. The panel surface side and the panel back surface side are interconnected through the passage between the panel bodies. Disadvantageously, due to the configuration of said photovoltaic power generation panel, air or wind, respectively, is inefficiently distributed, which only leads to a limited cooling effect of the panel surface, the cooling effect furthermore being limited to a narrow range of wind directions, and thus only leading to a limited improvement of the efficiency of the panel.

Patent publications US 2010/126554 A1, US 2014/299178 A1, US 6 061 978 A, EP 2 362 161 B1 and US 2005/263181 A1 disclose PV systems comprising wind management features such as particular spatial arrangement of the PV modules with respect to neighboring modules and the use of vanes to direct wind.

Accordingly, there is the object to provide a system comprising at least two photovoltaic modules and a method for arranging at least two photovoltaic modules in order to allow for directing wind in a highly efficient manner to the photovoltaic modules preferably for a broad range of wind directions, thereby especially reducing temperature, and thus increasing efficiency, of the latter.

This object is solved by the features of claim 1 for a system comprising at least two photovoltaic modules and the features of claim 14 for a method for arranging at least two photovoltaic modules. The dependent claims contain further developments.

According to a first aspect of the invention, a system is provided. Said system comprises at least two photovoltaic modules, each comprising a respective module area being substantially perpendicular to the thickness of the corresponding photovoltaic module, each of the at least two module areas comprising at least one of two first sides being substantially perpendicular to the thickness of the corresponding photovoltaic module and/or two second sides being substantially perpendicular to the thickness of the corresponding photovoltaic module. In this context, the at least two module areas are arranged in a substantially parallel manner with respect to each other and are shifted with respect to each other in an extension direction of the system. In addition to this, the at least two module areas are arranged in a staggering or alternating manner with respect to an extension plane in the extension direction of the system. Further additionally, the system and/or at least one of the at least two photovoltaic modules comprises multiple vanes being arranged in a region of at least one of the two first sides and/or the two second sides of the respective module area of the corresponding photovoltaic module.

Advantageously, wind can be directed in a highly efficient manner to the photovoltaic modules, thereby especially reducing temperature, and thus increasing efficiency, of the latter. In this context, an easy installation and low costs can be ensured. Further advantageously, no changes in respective production lines of photovoltaic modules and no maintenance are necessary.

With respect to the above-mentioned staggering manner, it is noted that in accordance with said staggering manner, a first module area, especially module areas with an odd number preferably in the extension direction, may be arranged in such a manner that said first module area faces a first surface of the extension plane, whereas a second module area, especially module areas with an even number preferably in the extension direction, may be arranged in such a manner that said second module area faces a second surface of the extension plane. In other words, a first module area of a first photovoltaic module, especially module areas of photovoltaic modules with an odd sequence number preferably in the extension direction, may be located at a first face of the extension plane, whereas a second module area of a second photovoltaic module, especially module areas of photovoltaic modules with an even sequence number preferably in the extension direction, may be located at a second, opposite, face of the extension plane. In this context, the distance of each of the module areas from the extension plane has not necessarily to be constant.

With respect to the above-mentioned alternating manner, it is noted that in accordance with said alternating manner, a first module area, especially module areas with an odd number preferably in the extension direction, may be arranged in such a manner that said first module area faces a first surface of the extension plane, whereas a second module area, especially module areas with an even number preferably in the extension direction, may be arranged in such a manner that said second module area faces a second surface of the extension plane. In other words, a first module area of a first photovoltaic module, especially module areas of photovoltaic modules with an odd sequence number preferably in the extension direction, may be located at a first face of the extension plane, whereas a second module area of a second photovoltaic module, especially module areas of photovoltaic modules with an even sequence number preferably in the extension direction, may be located at a second, opposite face of the extension plane. In this context, the distance of each of the module areas from the extension plane is typically constant.

Moreover, it is noted that it might be particularly advantageous if a structure for attaching the multiple vanes to the system and/or at least one of the at least two photovoltaic modules may be configured in a manner that wind can pass between the respective vanes and a surface, especially a front surface and/or a back surface, of the corresponding photovoltaic module.

With respect to the above-mentioned structure for attaching the multiple vanes, it is noted that said structure may especially comprise at least one, preferably at least two, crosspiece and/or at least one, preferably at least two, bridge or bridge element, respectively.

It is further noted that the two first sides of the respective module area of the corresponding photovoltaic module may be substantially parallel with respect to each other. In addition to this or as an alternative, the two second sides of the respective module area of the corresponding photovoltaic module may be substantially parallel with respect to each other. Further additionally or further alternatively, at least one of the two first sides of the respective module area of the corresponding photovoltaic module may be substantially perpendicular to at least one of the two second sides of the respective module area of the corresponding photovoltaic module.

According to a first preferred implementation form of the first aspect of the invention, at least one, preferably each, of the multiple vanes is configured to trap wind and/or to guide wind to a front surface being substantially parallel to the respective module area and/or a back surface being opposite to the front surface of the corresponding photovoltaic module and/or to the system. Advantageously, for instance, both sides of the corresponding photovoltaic module can be cooled, which leads to an increased efficiency of the corresponding photovoltaic module.

With respect to the front surface or the back surface, respectively, it is noted that the front surface of a photovoltaic cell or of a photovoltaic module especially refers to the surface adapted for being oriented towards a light source and thus for receiving illumination. However, in case of bifacial photovoltaic cells or modules, both surfaces are adapted to receive impinging light. In such case, the front surface is the surface adapted for receiving the largest fraction of the light or illumination. The back surface or rear surface of a photovoltaic cell or a photovoltaic module is the surface opposite to the front surface.

It is further noted that the front surface or the back surface of the corresponding photovoltaic module may comprise the respective module area. Alternatively, the respective module area may be located between, especially in the middle between, the front surface and the back surface of the corresponding photovoltaic module.

According to a second preferred implementation form of the first aspect of the invention, the respective distance of at least one, especially each, of the at least two module areas from the extension plane is a multiple, preferably a triple, more preferably a double, most preferably between 0.9- and 1.1-times, of the thickness of the corresponding photovoltaic module. Advantageously, in this manner, wind guiding can further be improved, which, for instance, leads to an increased air velocity, thereby ensuring a better cooling of the modules, and thus increasing their efficiency.

According to a further preferred implementation form of the first aspect of the invention, at least one, preferably each, of the at least two module areas is arranged at a tilt angle with respect to the extension plane and/or a horizontal plane. Advantageously, for example, by taking the geographical location of the system and the dominant wind direction into account, efficiency of the photovoltaic modules can further be increased in a highly efficient manner through a tilt angle being adapted accordingly.

According to a further preferred implementation form of the first aspect of the invention, the tilt angle is between 5 and 40 degrees, preferably between 10 and 35 degrees. Advantageously, in this manner, wind guiding can further be improved, thereby enhancing efficiency of the photovoltaic modules through better cooling.

According to a further preferred implementation form of the first aspect of the invention, a gap between each pair of the at least two module areas in the extension direction is between 0.045- and 0.055-times, preferably 0.05-times, of a dimension of one of the two first sides or the two second sides of one of the module areas of the respective pair. Advantageously, such a gap does not only allow for further improving wind guiding but also for preventing shading of the photovoltaic modules, which, especially in synergistic combination, increases output power of the photovoltaic modules.

According to a further preferred implementation form of the first aspect of the invention, at least one, preferably each, of the multiple vanes is configured in a curved manner and comprises a vane radius of curvature. Advantageously, the multiple vanes can be manufactured in an easy, and thus cost-efficient, manner.

According to a further preferred implementation form of the first aspect of the invention, the vane radius of curvature is between 4 and 6 centimeters, preferably between 4.5 and 5.5 centimeters, more preferably between 4.8 and 5.2 centimeters, most preferably 5 centimeters, especially for the case that the respective ones of the multiple vanes are located within a bottom volume comprising a back surface being opposite to a front surface of the corresponding photovoltaic module but not the front surface of the corresponding photovoltaic module.

In addition to this or as an alternative, the vane radius of curvature is between 16 and 22 centimeters, preferably between 18 and 20 centimeters, especially for the case that the respective ones of the multiple vanes are located within a top volume comprising a front surface of the corresponding photovoltaic module but not a back surface being opposite to the front surface of the corresponding photovoltaic module.

Advantageously, for instance, such radii allow for an optimum wind guiding, which leads to a particularly high efficiency of the photovoltaic modules.

Further advantageously, such a larger vane radius of curvature preferably for the top vanes exemplarily leads to a better cooling effect especially for 135 and 180 degree wind directions.

According to a further preferred implementation form of the first aspect of the invention, at least one, preferably each, of the multiple vanes is configured in a curved manner and comprises a vane arc length. Advantageously, for example, complexity of manufacturing such vanes can further be reduced, thereby allowing for an increased cost-efficiency.

According to a further preferred implementation form of the first aspect of the invention, the vane arc length, especially as mentioned above, depends on the tilt angle, especially as mentioned above, and/or the vane radius of curvature, especially as mentioned above. Advantageously, for instance, such a dependency allows for further improving wind guiding, which leads to a better cooling, thereby increasing efficiency of the photovoltaic modules.

According to a further preferred implementation form of the first aspect of the invention, the vane arc length, especially as mentioned above, is determined according to the following formula: $\frac{2\pi(\theta+10)}{360} \times ROC$ . In this context, $\theta$ denotes the tilt angle, especially as mentioned above, and ROC denotes the vane radius of curvature, especially as mentioned above. Advantageously, for example, the complexity of the above-mentioned dependency can be reduced to a minimum, thereby ensuring manufacturing the vanes in a highly cost-efficient manner.

Further advantageously, this also allows for further improving wind guiding towards the photovoltaic modules.

According to a further preferred implementation form of the first aspect of the invention, between 30 and 70 percent, preferably between 33 and 67 percent, more preferably between 40 and 60 percent, most preferably a half, of the multiple vanes is located within a top volume comprising a front surface of the corresponding photovoltaic module but not a back surface being opposite to the front surface of the corresponding photovoltaic module. Advantageously, for instance, wind guiding can be improved with special respect to the front surface of the corresponding photovoltaic module, which enhances cooling of the front surface in a highly efficient manner.

According to a further preferred implementation form of the first aspect of the invention, between 30 and 70 percent, preferably between 33 and 67 percent, more preferably between 40 and 60 percent, most preferably a half, of the multiple vanes is located within a bottom volume comprising a back surface being opposite to a front surface of the corresponding photovoltaic module but not the front surface of the corresponding photovoltaic module. Advantageously, for example, wind guiding can be improved with special respect to the back surface of the corresponding photovoltaic module, which enhances cooling of the back surface in a particularly efficient manner.

According to a second aspect of the invention, a method for arranging at least two photovoltaic modules, each comprising a respective module area being substantially perpendicular to the thickness of the corresponding photovoltaic module, each of the at least two module areas comprising at least one of two first sides being substantially perpendicular to the thickness of the corresponding photovoltaic module and/or two second sides being substantially perpendicular to the thickness of the corresponding photovoltaic module, is provided. Said method comprises the steps of arranging the at least two module areas in a substantially parallel manner with respect to each other, shifting the at least two module areas with respect to each other in an extension direction of the at least two photovoltaic modules, and arranging the at least two module areas in a staggering or alternating manner with respect to an extension plane in the extension direction of the at least two photovoltaic modules. In this context, said method further comprises arranging multiple vanes in a region of at least one of the two first sides and/or the two second sides of the respective module area of the corresponding photovoltaic module.

Advantageously, wind can be directed in a highly efficient manner to the photovoltaic modules, thereby especially reducing temperature, and thus increasing efficiency, of the latter. In this context, an easy installation at low costs can be ensured. Further advantageously, no changes in respective production lines of photovoltaic modules and no additional maintenance are necessary.

With respect to the above-mentioned staggering manner, it is noted that in accordance with said staggering manner, a first module area, especially module areas with an odd number preferably in the extension direction, may be arranged in such a manner that said first module area faces a first surface of the extension plane, whereas a second module area, especially module areas with an even number preferably in the extension direction, may be arranged in such a manner that said second module area faces a second surface of the extension plane. In other words, a first module area of a first photovoltaic module, especially module areas of photovoltaic modules with an odd sequence number preferably in the extension direction, may be located at a first face of the extension plane, whereas a second module area of a second photovoltaic module, especially module areas of photovoltaic modules with an even sequence number preferably in the extension direction, may be located at a second, opposite, face of the extension plane. In this context, the distance of each of the module areas from the extension plane has not necessarily to be constant.

With respect to the above-mentioned alternating manner, it is noted that in accordance with said alternating manner, a first module area, especially module areas with an odd number preferably in the extension direction, may be arranged in such a manner that said first module area faces a first surface of the extension plane, whereas a second module area, especially module areas with an even number preferably in the extension direction, may be arranged in such a manner that said second module area faces a second surface of the extension plane. In other words, a first module area of a first photovoltaic module, especially module areas of photovoltaic modules with an odd sequence number preferably in the extension direction, may be located at a first face of the extension plane, whereas a second module area of a second photovoltaic module, especially module areas of photovoltaic modules with an even sequence number preferably in the extension direction, may be located at a second, opposite, face of the extension plane. In this context, the distance of each of the module areas from the extension plane is typically constant.

Moreover, it is noted that it might be particularly advantageous if a structure for attaching the multiple vanes to the at least two photovoltaic modules and/or at least one of the at least two photovoltaic modules may be configured in a manner that wind can pass between the respective vanes and a surface, especially a front surface and/or a back surface, of the corresponding photovoltaic module.

In other words, it might be particularly advantageous if the method comprises the step of configuring a structure for attaching the multiple vanes to the at least two photovoltaic modules and/or at least one of the at least two photovoltaic modules in a manner that wind can pass between the respective vanes and a surface, especially a front surface and/or a back surface, of the corresponding photovoltaic module.

With respect to the above-mentioned structure for attaching the multiple vanes, it is noted that said structure may especially comprise at least one, preferably at least two, crosspiece and/or at least one, preferably at least two, bridge or bridge element, respectively.

It is further noted that the two first sides of the respective module area of the corresponding photovoltaic module may be substantially parallel with respect to each other. In addition to this or as an alternative, the two second sides of the respective module area of the corresponding photovoltaic module may be substantially parallel with respect to each other. Further additionally or further alternatively, at least one of the two first sides of the respective module area of the corresponding photovoltaic module may be substantially perpendicular to at least one of the two second sides of the respective module area of the corresponding photovoltaic module.

According to a first preferred implementation form of the second aspect of the invention, the method further comprises the step of configuring at least one, preferably each, of the multiple vanes to trap wind and/or to guide wind to a front surface being substantially parallel to the respective module area and/or a back surface being opposite to the front surface of the corresponding photovoltaic module and/or to the at least two photovoltaic modules.

Advantageously, for instance, both sides of the corresponding photovoltaic module can be cooled, which leads to an increased efficiency of the corresponding photovoltaic module.

With respect to the front surface or the back surface, respectively, it is noted that the front surface of a photovoltaic cell or of a photovoltaic module especially refers to the surface adapted for being oriented towards a light source and thus for receiving illumination. However, in case of bifacial photovoltaic cells or modules, both surfaces are adapted to receive impinging light. In such case, the front surface is the surface or side adapted for receiving the largest fraction of the light or illumination. The back surface or rear surface, of a photovoltaic cell or a photovoltaic module is the surface opposite to the front surface.

It is further noted that the front surface or the back surface of the corresponding photovoltaic module may comprise the respective module area. Alternatively, the respective module area may be located between, especially in the middle between, the front surface and the back surface of the corresponding photovoltaic module.

Exemplary embodiments of the invention are now further explained with respect to the drawings by way of example only, and not for limitation. In the drawings:

Fig. 1A shows an exemplary embodiment of an inventive system exemplarily comprising four photovoltaic modules;

Fig. 1B shows a further exemplary embodiment of an

Fig. 2       shows a further exemplary embodiment of an inventive system exemplarily comprising two photovoltaic modules;

Fig. 3       shows an exemplary finite element method model in the context of an exemplary inventive system;

Fig. 4A      shows exemplary contours of velocity magnitude around an exemplary conventional photovoltaic array;

Fig. 4B      shows exemplary contours of velocity magnitude around an exemplary photovoltaic array in the sense of the invention;

Fig. 5A      shows exemplary contours of temperature around an exemplary conventional photovoltaic array;

Fig. 5B      shows exemplary contours of temperature around an exemplary photovoltaic array in the sense of the invention;

Fig. 6A      shows exemplary contours of temperature around the fourth and final module in an exemplary conventional photovoltaic array;

Fig. 6B      shows exemplary contours of temperature around the fourth and final module in an exemplary photovoltaic array in the sense of the invention;

Fig. 7A      shows exemplary three-dimensional contours of temperature for the modules of an exemplary conventional photovoltaic array;

Fig. 7B      shows exemplary three-dimensional contours of temperature for the modules of an exemplary photovoltaic array in the sense of the invention;

Fig. 8       illustrates individual maximum temperatures in each of the modules for an exemplary conventional photovoltaic array and an exemplary photovoltaic array in the sense of the invention; and

Fig. 9       shows a flow chart of an embodiment of the second aspect of the invention.

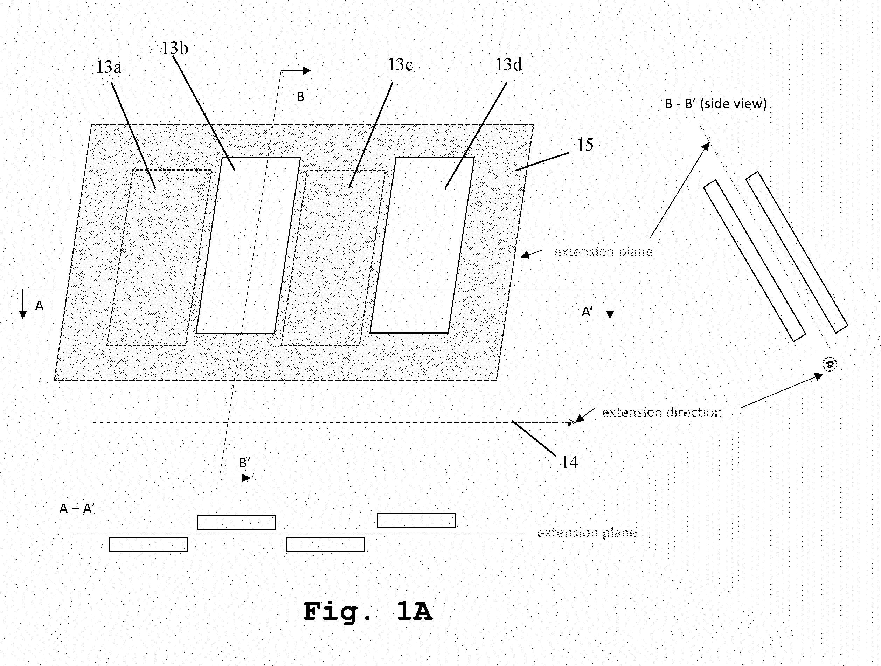

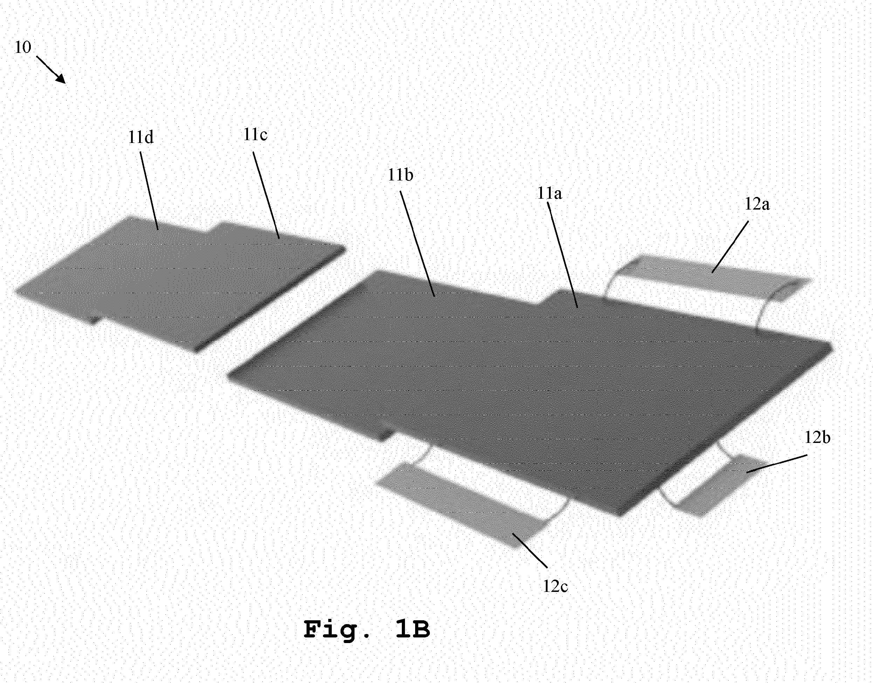

Fig. 1A depicts an exemplary embodiment of an inventive system exemplarily comprising four photovoltaic modules 13a, 13b, 13c, 13d.
As it can be seen from Fig. 1A, each of said four photovoltaic modules 13a, 13b, 13c, 13d comprises a respective module area being substantially perpendicular, exemplarily perpendicular, to the thickness of the corresponding photovoltaic module 13a, 13b, 13c, 13d.
Furthermore, each of the four module areas comprises at least one of two first sides being substantially perpendicular, exemplarily perpendicular, to the thickness of the corresponding photovoltaic module 13a, 13b, 13c, 13d and two second sides being substantially perpendicular, exemplarily perpendicular, to the thickness of the corresponding photovoltaic module 13a, 13b, 13c, 13d.
In this context, the four module areas are arranged in a substantially parallel, exemplarily parallel, manner with respect to each other and are shifted with respect to each other in an extension direction 14 of the system according to Fig. 1A.
In addition to this, the four module areas are exemplarily arranged in an alternating manner with respect to an extension plane 15 in the extension direction 14 of the system illustrated by Fig. 1A.
With respect to Fig. 1B, an exemplary embodiment 10 of an inventive system comprising at least two photovoltaic modules is shown. In this exemplary case, as it can be seen, the system comprises four photovoltaic modules 11a, 11b, 11c, 11d. In this context, multiple vanes 12a, 12b, 12c, preferably guiding vanes, more preferably wind guiding vanes, are attached to the first module 11a of said photovoltaic modules 11a, 11b, 11c, 11d.
In addition to this, the remaining photovoltaic modules 11b, 11c, 11d or panels, respectively, of the system or the photovoltaic array, respectively, are periodically staggered especially to simulate the effect of the above-mentioned vane 12b for the respective other modules.
Advantageously, it is noted that especially the combination of staggering of the modules with vanes 12a and 12c enables capturing wind from many different wind directions
Generally, such an inventive configuration as illustrated by Fig. 1B increases the air velocity at the front surface and/or the back surface of the respective panels especially to enhance heat transfer by convection and lower the module temperature. This is exemplarily done by affixing especially-designed guiding-vane(s) in critical areas on the peripheries of the corresponding module to aid in the channeling of wind to the frontside and/or the backside of the corresponding module.
Furthermore, it is also generally noted that vanes, especially guiding vanes, can be placed on one or more sides of the corresponding module, especially to capture wind from multiple directions. The dimensions and locations of the vanes can advantageously be optimized based on the geographical location and/or the dominant wind direction.
Additionally or alternatively, the vanes, especially guiding vanes, on the top and bottom can cover single modules or be extended to cover multiple ones. Moreover, especially in the case of photovoltaic arrays, and preferably to complement the effect of these vanes, the modules themselves are advantageously staggered in and out of plane especially to simulate the effect of multiple vanes.

For the sake of completeness, it is to be pointed out that invention typically leads to the following advantages:

- With respect to production lines of photovoltaic modules, no changes have to be made.
- An easy installation of the photovoltaic modules and of the vanes can be ensured.
- Low costs can be guaranteed: an efficient cooling of the photovoltaic modules is realized in a passive way, not consuming power.
- Additional maintenance is not required, as the vanes do not require any maintenance.
- The invention is immediately deployable in current photovoltaic power plants.
- The invention is effective for a broad range of wind directions.
- The invention is effective for enhanced heat transfer both at the front and back surface of the photovoltaic modules.
- The invention is suitable for systems comprising bifacial photovoltaic modules.

In addition to this, it can especially be summarized that the invention revolves around the addition of especially-designed guiding vanes in specific areas along the perimeter of the corresponding photovoltaic module. These vanes typically guide the surrounding wind toward dead zones around the corresponding module where heat could be trapped.

This especially increases the air velocity at both front and back surfaces of the corresponding module which reduces the operating temperature of the module, and thus increases its efficiency. Moreover, especially for the case of an array of photovoltaic modules, the guiding vanes can be installed individually, or, for ease of manufacturing and installation, be extended through the width of the array.

Further advantageously, the modules can also be installed in a staggered configuration, in- and out-of-plane, especially to simulate the effect of the guiding vanes longitudinally.

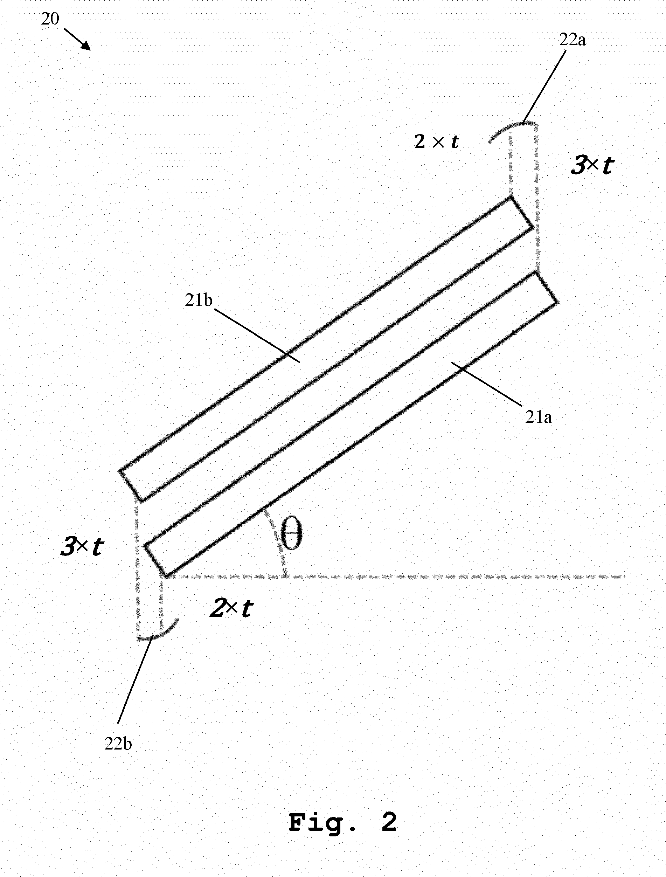

Now, with respect to Fig. 2, an exemplary embodiment 20 of an inventive system is shown. In this exemplary case, as it can be seen, the system comprises two photovoltaic modules 21a, 21b. Specifically, Fig. 2 is a side view showing two staggered modules 21a, 21b with top and bottom vanes 22a, 22b.

Advantageously, in this exemplary case, all required specifications especially are in terms of either module thickness (t) or module length (l) or module tilt angle ($\theta$). Further advantageously, in terms of module dimensions, the vanes 22a, 22b and staggering can be applied to any commercially available module.

In this context, for the module tilt angle $\theta$, the following range should preferably be used: 10°-35°. Furthermore, for staggering, especially in- and out-of-plane arrangement of modules, the following should preferably apply: $1 \times t \pm 10\%$. Additionally or alternatively, for at least one, especially each, gap preferably in extension direction between modules, the following should preferably apply: $0.05 \times l \pm 10\%$.

Moreover, for a vane radius of curvature (ROC), 5 cm $\pm 10\%$ may preferably apply, whereas for a vane arc length, the following should preferably apply:

$$\frac{2\pi(\theta+10)}{360} \times ROC$$
.

Although the invention is illustrated and described above in particular for exemplary embodiments of a system wherein the at least two photovoltaic modules are arranged in a 1D array (i.e. in a row), it is not limited thereto. In embodiments of a system according to the invention, the photovoltaic modules may be arranged in a 2D array, i.e. the photovoltaic modules may be arranged in a matrix configuration comprising multiple rows, e.g. multiple parallel rows of photovoltaic modules.

In embodiments wherein the photovoltaic modules are arranged in a 2D array, arranging the module areas in a staggering manner may comprise arranging the module areas such that neighboring modules are arranged in a staggering manner in both main directions of the 2D array, e.g. in two substantially orthogonal directions of the 2D array, e.g. in a first direction corresponding to a direction of a row of photovoltaic modules and in a second direction corresponding to a direction substantially orthogonal to a row of photovoltaic modules. In other words, the photovoltaic modules may be staggered according to a checkerboard pattern.

In embodiments wherein the photovoltaic modules are arranged in a 2D array, arranging the module areas in an alternating manner may comprise arranging the module areas such that neighboring modules are arranged in an alternating manner in both main directions of the 2D array, e.g. in two substantially orthogonal directions of the 2D array, e.g. in a first direction corresponding to a direction of a row of photovoltaic modules and in a second direction corresponding to a direction substantially orthogonal to a row of photovoltaic modules. In other words, the photovoltaic modules may be alternated according to a checkerboard pattern.

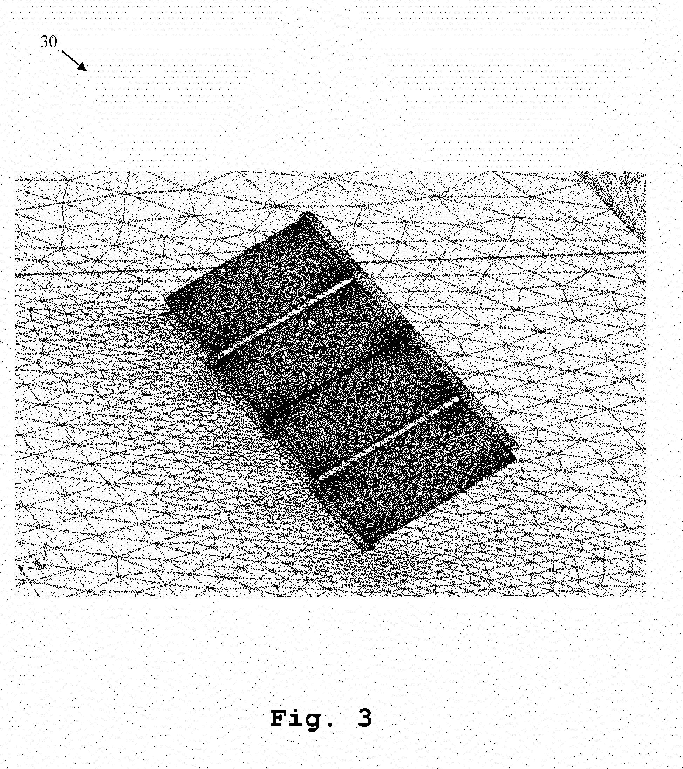

Fig. 3 illustrates an exemplary finite element method (FEM) model, especially a three-dimensional FEM model 30, in the context of an exemplary inventive system such as the above-mentioned system 10 according to Fig. 1B with four photovoltaic modules.

Said three-dimensional FEM model has been tested under the following assumptions:

1. Inclination angle of the photovoltaic modules is 30° from the horizontal plane and facing south.

2. Irradiance is 1000 W/m$^2$.

3. Module efficiency of 20%.

4. Wind direction 50th-percentile of annual measurements in Kuwait (1-hour resolution).

5. Ambient temperature is 50th-percentile of annual measurements in Kuwait (1-hour resolution).

6. Top and bottom vanes, such as vanes 12a and 12c of Fig. 1B, have been extended for the entire width of the array.

7. No side vanes, such as vane 12b of Fig. 1B, were used for the simulation.

It is further noted that the FEM model has been run for five different incoming wind directions, from 0 to 180° (with 45°-increments), 0 being due south, with and without the vanes, especially guiding vanes.

The model has been limited to the module only, i.e., without inverters, cabling, junction boxes, etc. The module especially is a glass-glass module. The silicon and encapsulant layers were thermally lumped with the glass layer. This especially simplifies the FEM model preferably by avoiding the modeling of the widely differing scales. This is justified by the fact that these layers account for negligible fractions of the energy conducted, due to their very small thickness. In this context, Fig. 3 especially shows a partial view of the meshed domain.

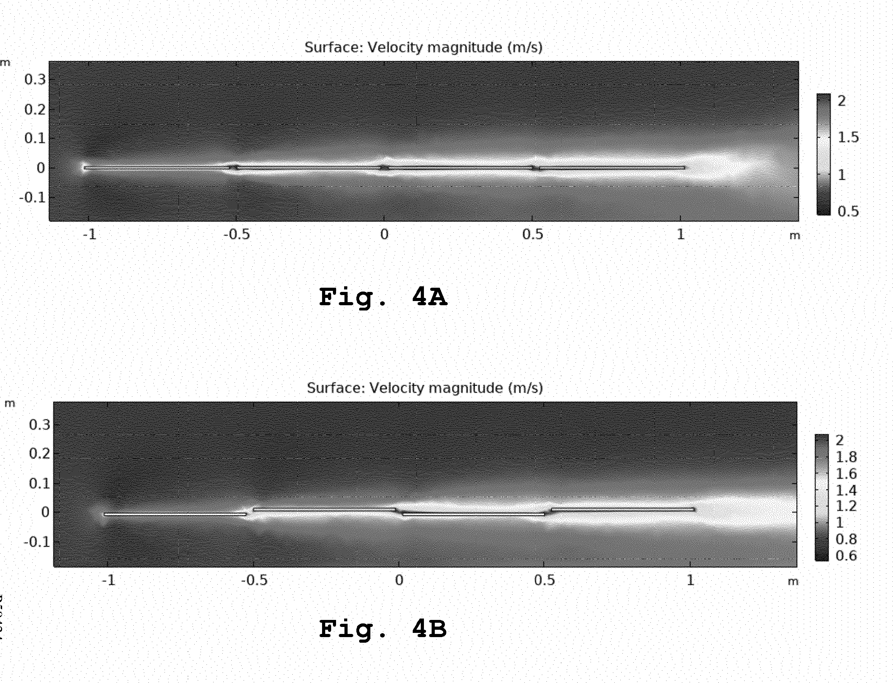

Now, with respect to Fig. 4A, contours of velocity magnitude around an exemplary conventional photovoltaic array are shown, whereas Fig. 4B illustrates contours of velocity magnitude around an exemplary staggered array in the sense of the invention especially for the case of 90 degrees incoming wind direction.

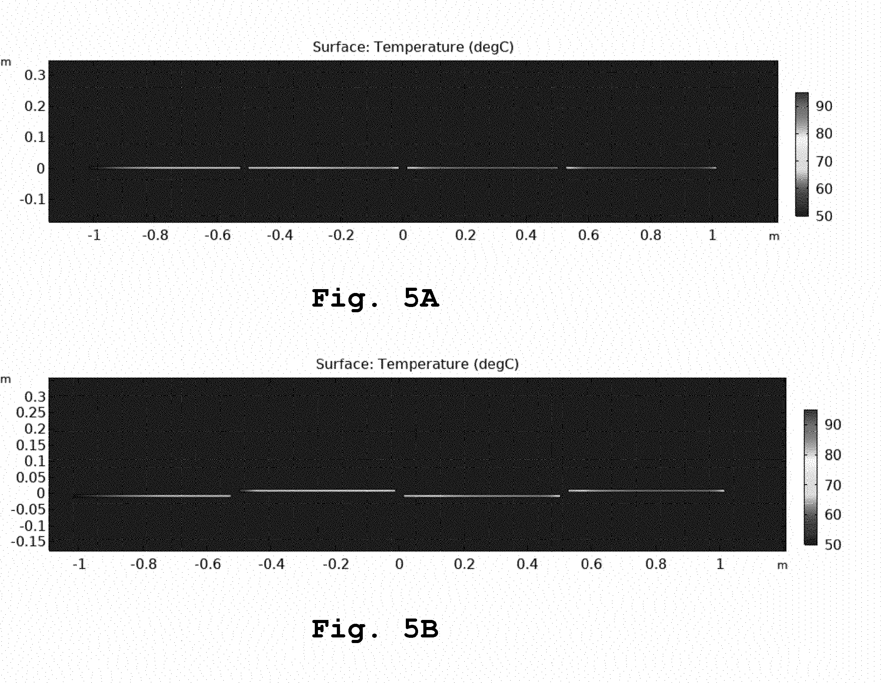

By analogy with Fig. 4A and Fig. 4B, Fig. 5A depicts contours of temperature around an exemplary conventional photovoltaic array, whereas Fig. 5B shows contours of temperature around an exemplary staggered array in the sense of the invention.

Advantageously, it can be seen from Fig. 4A or Fig. 4B, respectively, that staggering especially allows cool air from the surroundings to pass through in-between the modules, lowering the temperature as it can be seen in Fig. 5A or Fig. 5B, respectively. Exemplarily, the maximum temperature in the array can advantageously be reduced by more than 5.6 degrees Celsius for the case of the 90° incoming wind direction.

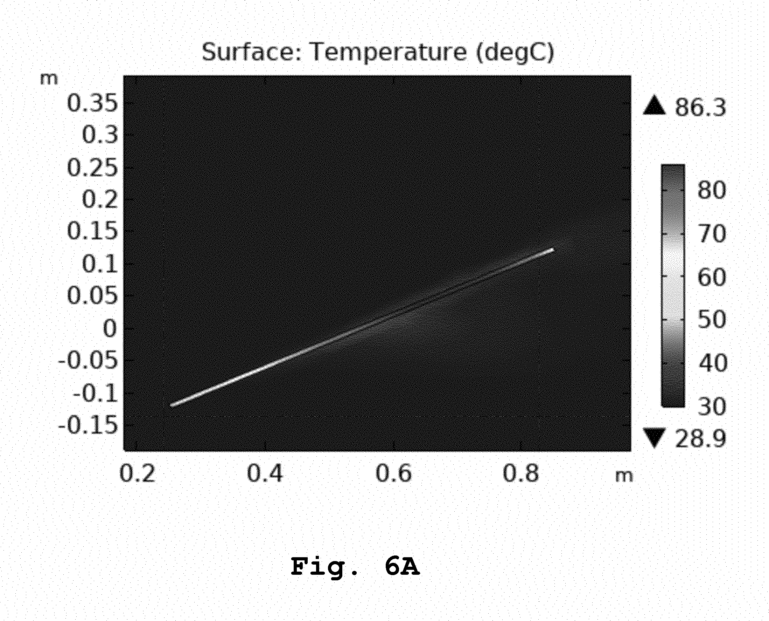

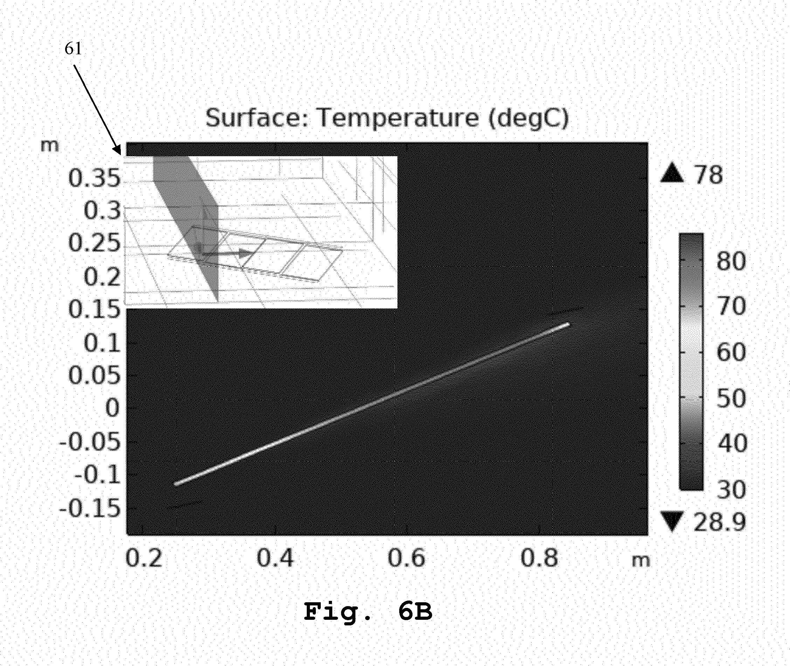

Further exemplarily, the corresponding 45 degrees incoming wind case elucidates the efficacy of the guiding vanes. Fig. 6A or Fig. 6B, respectively, show the temperature contours around the fourth module for the cases without (Fig. 6A) and with the inventive guiding vanes and staggering (Fig. 6B). In this context, the insert 61 in Fig. 6B shows the location of the respective two-dimensional cut in the domain.

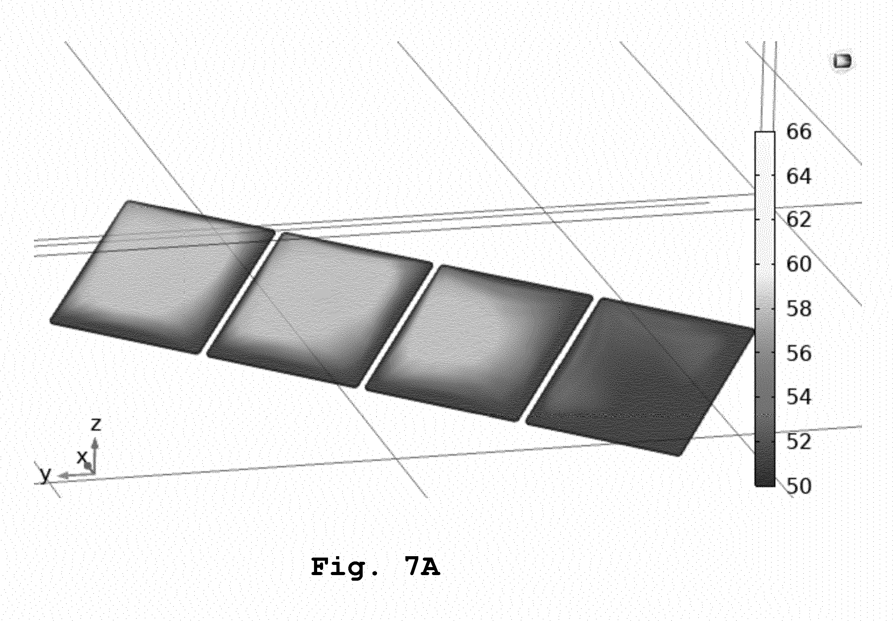

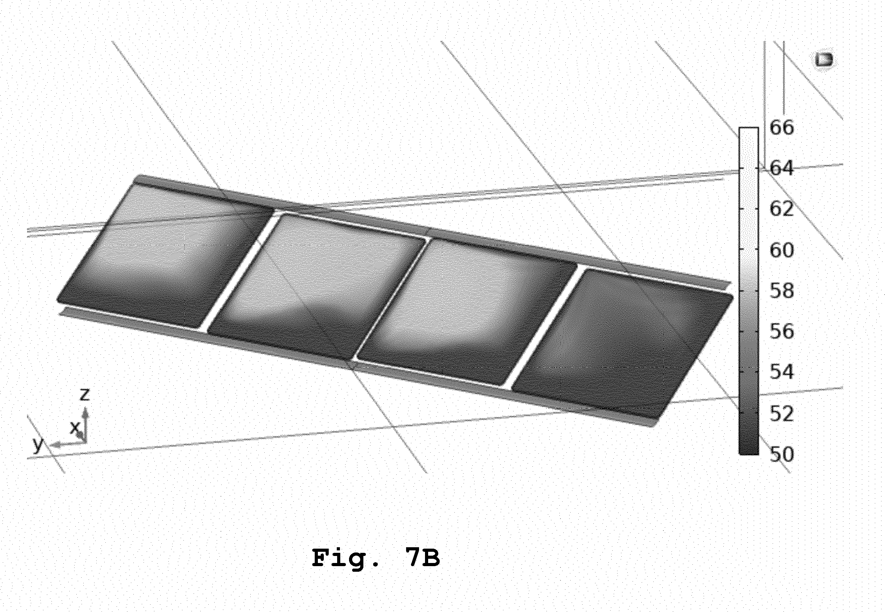

In addition to this, for this exemplary case, Fig. 7A or Fig. 7B, respectively, also show the corresponding three-dimensional temperature contours in the modules. Accordingly, said Fig. 7A shows the three-dimensional contours of temperature for the modules of the exemplary conventional photovoltaic array, whereas said Fig. 7B illustrates the three-dimensional contours of temperature for the modules of the exemplary staggered array with guiding vanes in the sense of the invention especially for the case of 45 degrees incoming wind direction.

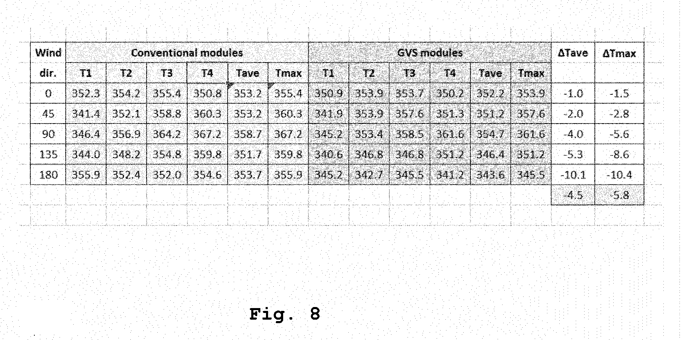

With respect to the above-mentioned conventional and staggered with vanes (GVS) cases, the table according to Fig. 8 especially summarizes the corresponding numerical results. The (reduction) in maximum temperature in each of the four modules for each case is given, as well as the maximum among them and their averages, for each wind direction.

Advantageously, as it can be seen from said table of Fig. 8, the use of GVS or the invention, respectively, gives an average reduction of 1.6 degrees Celsius in the maximum module temperature, across all wind directions.

Further advantageously, for the sake of completeness, it should be noted that a larger vane radius of curvature preferably for the top vanes exemplarily leads to a better cooling effect especially for the 135 and 180 degree wind directions.

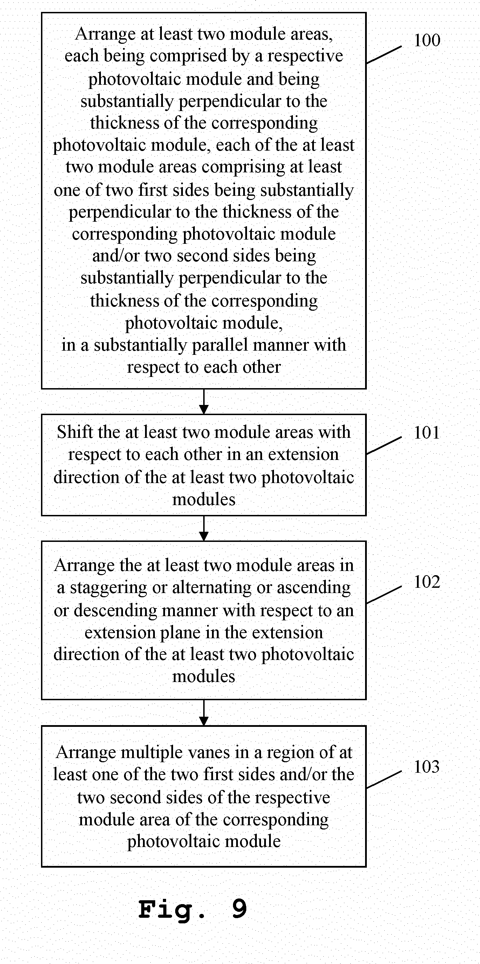

Finally, Fig. 9 shows a flow chart of an embodiment of the inventive method for arranging at least two photovoltaic modules, each comprising a respective module area being substantially perpendicular to the thickness of the corresponding photovoltaic module, each of the at least two module areas comprising at least one of two first sides being substantially perpendicular to the thickness of the corresponding photovoltaic module and/or two second sides being substantially perpendicular to the thickness of the corresponding photovoltaic module. In a first step 100, the at least two module areas are arranged in a substantially parallel manner with respect to each other.

Then, in a second step 101, the at least two module areas are shifted with respect to each other in an extension direction of the at least two photovoltaic modules. Furthermore, in a third step 102, the at least two module areas are arranged in a staggering or alternating manner with respect to an extension plane in the extension direction of the at least two photovoltaic modules. In a fourth step 103, multiple vanes are arranged in a region of at least one of the two first sides and/or the two second sides of the respective module area of the corresponding photovoltaic module.

It is noted that it might be particularly advantageous if the method further comprises the step of configuring at least one, preferably each, of the multiple vanes to trap wind and/or to guide wind to a front surface being substantially parallel to the respective module area and/or a back surface being opposite to the front surface of the corresponding photovoltaic module and/or to the at least two photovoltaic modules.

It is further noted that the respective distance of at least one, especially each, of the at least two module areas from the extension plane may be a multiple, preferably a triple, more preferably a double, most preferably between 0.9- and 1.1-times, of the thickness of the corresponding photovoltaic module.

In other words, the method may additionally or alternatively comprise the step of arranging the at least two photovoltaic modules such that the respective distance of at least one, especially each, of the at least two module areas from the extension plane may be a multiple, preferably a triple, more preferably a double, most preferably between 0.9- and 1.1-times, of the thickness of the corresponding photovoltaic module.

Furthermore, at least one, preferably each, of the at least two module areas may especially be arranged at a tilt angle with respect to a horizonal plane. In other words, the method may additionally or alternatively comprise the step of arranging at least one, preferably each, of the at least two module areas at a tilt angle with respect to the horizontal plane. In this context, it might be particularly advantageous if the tilt angle is between 5 and 40 degrees, preferably between 10 and 35 degrees.

Moreover, it is noted that a gap between each pair of the at least two module areas in the extension direction may especially be between 0.045- and 0.055-times, preferably 0.05-times, of a dimension of one of the two first sides or the two second sides of one of the module areas of the respective pair. In other words, the method may additionally or alternatively comprise the step of arranging the at least two photovoltaic modules such that a gap between each pair of the at least two module areas in the extension direction may especially be between 0.045- and 0.055-times, preferably 0.05-times, of a dimension of one of the two first sides or the two second sides of one of the module areas of the respective pair.

Furthermore, it might be particularly advantageous if at least one, preferably each, of the multiple vanes is configured in a curved manner and comprises a vane radius of curvature. In other words, the method may additionally or alternatively comprise the step of configuring at least one, preferably each, of the multiple vanes in a curved manner, wherein at least one, preferably each, of the multiple vanes comprises a vane radius of curvature. In this context, it might be particularly advantageous if the vane radius of curvature is between 4 and 6 centimeters, preferably between 4.5 and 5.5 centimeters, more preferably between 4.8 and 5.2 centimeters, most preferably 5 centimeters, especially for the case that the respective ones of the multiple vanes are located within a bottom volume comprising a back surface being opposite to a front surface of the corresponding photovoltaic module but not the front surface of the corresponding photovoltaic module.

In addition to this or as an alternative, the vane radius of curvature is between 16 and 22 centimeters, preferably between 18 and 20 centimeters, especially for the case that the respective ones of the multiple vanes are located within a top volume comprising a front surface of the corresponding photovoltaic module but not a back surface being opposite to the front surface of the corresponding photovoltaic module.

Moreover, it is noted that at least one, preferably each, of the multiple vanes may especially be configured in a curved manner and may especially comprise a vane arc length. In other words, the method may additionally or alternatively comprise the step of configuring at least one, preferably each, of the multiple vanes in a curved manner, wherein at least one, preferably each, of the multiple vanes comprises a vane arc length.

It is noted that it might be particularly advantageous if the vane arc length, especially as mentioned above, depends on the tilt angle, especially as mentioned above, and/or the vane radius of curvature, especially as mentioned above.

It is further noted that it might be particularly advantageous if the vane arc length, especially as mentioned above, is determined according to the following formula:

$$\frac{2\pi(\theta+10)}{360} \times ROC$$

. In this context, $\theta$ denotes the tilt angle, especially as mentioned above, and $ROC$ denotes the vane radius of curvature, especially as mentioned above.

Furthermore, it might be particularly advantageous if between 30 and 70 percent, preferably between 33 and 67 percent, more preferably between 40 and 60 percent, most preferably a half, of the multiple vanes is located within a top volume comprising a front surface of the corresponding photovoltaic module but not a back surface being opposite to the front surface of the corresponding photovoltaic module.

In other words, the method may additionally or alternatively comprise the step of locating between 30 and 70 percent, preferably between 33 and 67 percent, more preferably between 40 and 60 percent, most preferably a half, of the multiple vanes within a top volume comprising a front surface of the corresponding photovoltaic module but not a back surface being opposite to the front surface of the corresponding photovoltaic module.

Moreover, it might be particularly advantageous if between 30 and 70 percent, preferably between 33 and 67 percent, more preferably between 40 and 60 percent, most preferably a half, of the multiple vanes is located within a bottom volume comprising a back surface being opposite to a front surface of the corresponding photovoltaic module but not the front surface of the corresponding photovoltaic module.

In other words, the method may additionally or alternatively comprise the step of locating between 30 and 70 percent, preferably between 33 and 67 percent, more preferably between 40 and 60 percent, most preferably a half, of the multiple vanes within a bottom volume comprising a back surface being opposite to a front surface of the corresponding photovoltaic module but not the front surface of the corresponding photovoltaic module.

While various embodiments of the present invention have been described above, it should be understood that they have been presented by way of example only, and not limitation. Numerous changes to the disclosed embodiments can be made in accordance with the disclosure herein without departing from the invention as defined by the following claims.

**Claims**

1.    A system (10, 20) comprising:
at least two photovoltaic modules (11a, 11b, 11c, 11d, 13a, 13b, 13c, 13d, 21a, 21b), each comprising a respective module area being substantially perpendicular to the thickness of the corresponding photovoltaic module (11a, 11b, 11c, 11d, 13a, 13b, 13c, 13d, 21a, 21b), each of the at least two module areas comprising at least one of two first sides being substantially perpendicular to the thickness of the corresponding photovoltaic module (11a, 11b, 11c, 11d, 13a, 13b, 13c, 13d, 21a, 21b) and/or two second sides being substantially perpendicular to the thickness of the corresponding photovoltaic module (11a, 11b, 11c, 11d, 13a, 13b, 13c, 13d, 21a, 21b),

wherein the at least two module areas are arranged in a substantially parallel manner with respect to each other and are shifted with respect to each other in an extension direction (14) of the system (10, 20),
wherein the at least two module areas are arranged in a staggering or alternating manner with respect to an extension plane (15) in the extension direction (14) of the system (10, 20), **characterized in that** the system (10, 20) and/or at least one of the at least two photovoltaic modules (11a, 11b, 11c, 11d, 13a, 13b, 13c, 13d, 21a, 21b) comprises multiple vanes (12a, 12b, 12c, 22a, 22b) being arranged in a region of at least one of the two first sides and/or the two second sides of the respective module area of the corresponding photovoltaic module (11a, 11b, 11c, 11d, 13a, 13b, 13c, 13d, 21a, 21b).

2.    The system (10, 20) according to claim 1,
wherein at least one, preferably each, of the multiple vanes (12a, 12b, 12c, 22a, 22b) is configured to trap wind and/or to guide wind to a front surface being substantially parallel to the respective module area and/or a back surface being opposite to the front surface of the corresponding photovoltaic module (11a, 11b, 11c, 11d, 13a, 13b, 13c, 13d, 21a, 21b) and/or to the system (10, 20).

3.    The system (10, 20) according to claim 1 or 2,
wherein the respective distance of at least one, especially each, of the at least two module areas from the extension plane (15) is a multiple, preferably a triple, more preferably a double, most preferably between 0.9- and 1.1-times, of the thickness of the corresponding photovoltaic module (11a, 11b, 11c, 11d, 13a, 13b, 13c, 13d, 21a, 21b).

4.    The system (10, 20) according to any of the claims 1 to 3,
wherein at least one, preferably each, of the at least two module areas is arranged at a tilt angle with respect to the extension plane (15) and/or a horizontal plane.

5.    The system (10, 20) according to claim 4,
wherein the tilt angle is between 5 and 40 degrees, preferably between 10 and 35 degrees.

6.    The system (10, 20) according to any of the claims 1 to 5,
wherein a gap between each pair of the at least two module areas in the extension direction (14) is between 0.045- and 0.055-times, preferably 0.05-times, of a dimension of one of the two first sides or the two second sides of one of the module areas of the respective pair.

7.    The system (10, 20) according to any of the claims 1 to 6,
wherein at least one, preferably each, of the multiple vanes (12a, 12b, 12c, 22a, 22b) is configured in a curved manner and comprises a vane radius of curvature.

8.    The system (10, 20) according to claim 7,

wherein the vane radius of curvature is between 4 and 6 centimeters, preferably between 4.5 and 5.5 centimeters, more preferably between 4.8 and 5.2 centimeters, most preferably 5 centimeters, especially for the case that the respective ones of the multiple vanes (12a, 12b, 12c, 22a, 22b) are located within a bottom volume comprising a back surface being opposite to a front surface of the corresponding photovoltaic module (11a, 11b, 11c, 11d, 13a, 13b, 13c, 13d, 21a, 21b) but not the front surface of the corresponding photovoltaic module (11a, 11b, 11c, 11d, 13a, 13b, 13c, 13d, 21a, 21b), and/or wherein the vane radius of curvature is between 16 and 22 centimeters, preferably between 18 and 20 centimeters, especially for the case that the respective ones of the multiple vanes (12a, 12b, 12c, 22a, 22b) are located within a top volume comprising a front surface of the corresponding photovoltaic module (11a, 11b, 11c, 11d, 13a, 13b, 13c, 13d, 21a, 21b) but not a back surface being opposite to the front surface of the corresponding photovoltaic module (11a, 11b, 11c, 11d, 13a, 13b, 13c, 13d, 21a, 21b).

9. The system (10, 20) according to any of the claims 1 to 8,
wherein at least one, preferably each, of the multiple vanes (12a, 12b, 12c, 22a, 22b) is configured in a curved manner and comprises a vane arc length.

10. The system (10, 20) according to any of the claims 4 to 9,
wherein the vane arc length according to claim 9 depends on the tilt angle according to any of the claims 4 to 9 and/or the vane radius of curvature according to any of the claims 7 to 9.

11. The system (10, 20) according to any of the claims 4 to 10,

wherein the vane arc length according to claim 9 or 10 is determined according to the following formula:

$$\frac{2\pi(\theta+10)}{360} \times ROC \quad,$$

wherein $\theta$ denotes the tilt angle according to any of the claims 4 to 10, and
wherein $ROC$ denotes the vane radius of curvature according to any of the claims 7 to 10.

12. The system (10, 20) according to any of the claims 1 to 11,
wherein between 30 and 70 percent, preferably between 33 and 67 percent, more preferably between 40 and 60 percent, most preferably a half, of the multiple vanes (12a, 12b, 12c, 22a, 22b) is located within a top volume comprising a front surface of the corresponding photovoltaic module (11a, 11b, 11c, 11d, 13a, 13b, 13c, 13d, 21a, 21b) but not a back surface being opposite to the front surface of the corresponding photovoltaic module (11a, 11b, 11c, 11d, 13a, 13b, 13c, 13d, 21a, 21b).

13. The system (10, 20) according to any of the claims 1 to 12,
wherein between 30 and 70 percent, preferably between 33 and 67 percent, more preferably between 40 and 60 percent, most preferably a half, of the multiple vanes (12a, 12b, 12c, 22a, 22b) is located within a bottom volume comprising a back surface being opposite to a front surface of the corresponding photovoltaic module (11a, 11b, 11c, 11d, 13a, 13b, 13c, 13d, 21a, 21b) but not the front surface of the corresponding photovoltaic module (11a, 11b, 11c, 11d, 13a, 13b, 13c, 13d, 21a, 21b).

14. A method for arranging at least two photovoltaic modules (11a, 11b, 11c, 11d, 13a, 13b, 13c, 13d, 21a, 21b), each comprising a respective module area being substantially perpendicular to the thickness of the corresponding photovoltaic module (11a, 11b, 11c, 11d, 13a, 13b, 13c, 13d, 21a, 21b), each of the at least two module areas comprising at least one of two first sides being substantially perpendicular to the thickness of the corresponding photovoltaic module (11a, 11b, 11c, 11d, 13a, 13b, 13c, 13d, 21a, 21b) and/or two second sides being substantially perpendicular to the thickness of the corresponding photovoltaic module (11a, 11b, 11c, 11d, 13a, 13b, 13c, 13d, 21a, 21b), the method comprising the steps of:

arranging (100) the at least two module areas in a substantially parallel manner with respect to each other,
shifting (101) the at least two module areas with respect to each other in an extension direction (14) of the at least two photovoltaic modules (11a, 11b, 11c, 11d, 13a, 13b, 13c, 13d, 21a, 21b),
arranging (102) the at least two module areas in a staggering or alternating manner with respect to an extension plane (15) in the extension direction (14) of the at least two photovoltaic modules (11a, 11b, 11c, 11d, 13a, 13b, 13c, 13d, 21a, 21b), and
arranging (103) multiple vanes (12a, 12b, 12c, 22a, 22b) in a region of at least one of the two first sides and/or the two second sides of the respective module area of the corresponding photovoltaic module (11a, 11b, 11c, 11d, 13a, 13b, 13c, 13d, 21a, 21b).

15. The method according to claim 14,
wherein the method further comprises the step of configuring at least one, preferably each, of the multiple vanes (12a, 12b, 12c, 22a, 22b) to trap wind and/or to guide wind to a front surface being substantially parallel to the respective module area and/or a back surface being opposite to the front surface of the corresponding photovoltaic module (11a, 11b, 11c, 11d, 13a, 13b, 13c, 13d, 21a, 21b) and/or to the at least two photovoltaic modules (11a, 11b, 11c, 11d, 13a, 13b, 13c, 13d, 21a, 21b).

**Patentansprüche**

1. Ein System (10, 20), aufweisend:

zumindest zwei Photovoltaikmodule (11a, 11b, 11c, 11d, 13a, 13b, 13c, 13d, 21a, 21b), die jeweils eine entsprechende, zur Dicke des entsprechenden Photovoltaikmoduls (11a, 11b, 11c, 11d, 13a, 13b, 13c, 13d, 21a, 21b) im Wesentlichen senkrechte Modulfläche aufweisen, wobei jede der zumindest zwei Modulflächen zumindest eine von zwei ersten, zur Dicke des entsprechenden Photovoltaikmoduls (11a, 11b, 11c, 11d, 13a, 13b, 13c, 13d, 21a, 21b) im Wesentlichen senkrechte Seiten und/oder zwei zweiten, zur Dicke des entsprechenden Photovoltaikmoduls (11a, 11b, 11c, 11d, 13a, 13b, 13c, 13d, 21a, 21b) im Wesentlichen senkrechte Seiten, aufweist,

wobei die zumindest zwei Modulflächen im Wesentlichen parallel zueinander angeordnet und in einer Erstreckungsrichtung (14) des Systems (10, 20) gegeneinander verschoben sind,

wobei die zumindest zwei Modulflächen in Bezug auf eine Erstreckungsebene (15) in Erstreckungsrichtung (14) des Systems (10, 20) versetzt oder alternierend angeordnet sind, **dadurch gekennzeichnet, dass**

das System (10, 20) und/oder zumindest eines der zumindest zwei Photovoltaikmodule (11a, 11b, 11c, 11d, 13a, 13b, 13c, 13d, 21a, 21b) mehrere Lamellen (12a, 12b, 12c, 22a, 22b) aufweist, die in einem Bereich zumindest einer der beiden ersten Seiten und/oder der beiden zweiten Seiten der jeweiligen Modulfläche des entsprechenden Photovoltaikmoduls (11a, 11b, 11c, 11d, 13a, 13b, 13c, 13d, 21a, 21b) angeordnet sind.

2. Das System (10, 20) nach Anspruch 1, wobei zumindest eine, vorzugsweise jede der mehreren Lamellen (12a, 12b, 12c, 22a, 22b) so ausgebildet ist, dass sie Wind einfängt und/oder Wind zu einer zu der jeweiligen Modulfläche im Wesentlichen parallelen vorderen Fläche und/oder zu einer der vorderen Fläche des entsprechenden Photovoltaikmoduls (11a, 11b, 11c, 11d, 13a, 13b, 13c, 13d, 21a, 21b) gegenüberliegenden hinteren Fläche und/oder zu dem System (10, 20) leitet.

3. Das System (10, 20) nach Anspruch 1 oder 2, wobei der jeweilige Abstand zumindest einer, insbesondere jeder der zumindest zwei Modulflächen von der Erstreckungsebene (15) ein Vielfaches, vorzugsweise ein Dreifaches, noch bevorzugter ein Doppeltes, am meisten bevorzugt zwischen dem 0,9- und 1,1-fachen, der Dicke des entsprechenden Photovoltaikmoduls (11a, 11b, 11c, 11d, 13a, 13b, 13c, 13d, 21a, 21b) beträgt.

4. Das System (10, 20) nach einem der Ansprüche 1 bis 3, wobei zumindest eine, vorzugsweise jede der zumindest zwei Modulflächen gegenüber der Erstreckungsebene (15) und/oder einer horizontalen Ebene in einem Neigungswinkel angeordnet ist.

5. Das System (10, 20) nach Anspruch 4,

wobei der Neigungswinkel zwischen 5 und 40 Grad, vorzugsweise zwischen 10 und 35 Grad, liegt.

6. Das System (10, 20) nach einem der Ansprüche 1 bis 5, wobei ein Abstand zwischen jedem Paar der zumindest zwei Modulflächen in Erstreckungsrichtung (14) zwischen dem 0,045- und 0,055-fachen, vorzugsweise dem 0,05-fachen, einer Abmessung einer der beiden ersten Seiten oder der beiden zweiten Seiten einer der Modulflächen des jeweiligen Paares beträgt.

7. Das System (10, 20) nach einem der Ansprüche 1 bis 6, wobei zumindest eine, vorzugsweise jede, der mehreren Lamellen (12a, 12b, 12c, 22a, 22b) gekrümmt ausgebildet ist und einen Lamellenkrümmungsradius aufweist.

8. Das System (10, 20) nach Anspruch 7,

wobei der Lamellenkrümmungsradius zwischen 4 und 6 Zentimetern, vorzugsweise zwischen 4,5 und 5,5 Zentimetern, noch bevorzugter zwischen 4,8 und 5,2 Zentimetern, am meisten bevorzugt bei 5 Zentimetern, liegt, insbesondere für den Fall, dass die jeweiligen der mehreren Lamellen (12a, 12b, 12c, 22a, 22b) innerhalb eines unteren Volumens angeordnet sind, welches eine einer vorderen Fläche des entsprechenden Photovoltaikmoduls (11a, 11b, 11c, 11d, 13a, 13b, 13c, 13d, 21a, 21b) gegenüberliegende hintere Fläche aufweist, nicht aber die vordere Fläche des entsprechenden Photovoltaikmoduls (11a, 11b, 11c, 11d, 13a, 13b, 13c, 13d, 21a, 21b), und/oder

wobei der Lamellenkrümmungsradius zwischen 16 und 22 Zentimetern, vorzugsweise zwischen 18 und 20 Zentimetern liegt, insbesondere für den Fall, dass die jeweiligen der mehreren Lamellen (12a, 12b, 12c, 22a, 22b) innerhalb eines oberen Volumens angeordnet sind, welches eine vordere Fläche des entsprechenden Photovoltaikmoduls (11a, 11b, 11c, 11d, 13a, 13b, 13c, 13d, 21a, 21b) aufweist, nicht aber eine hintere Fläche, die der vorderen Fläche des entsprechenden Photovoltaikmoduls (11a, 11b, 11c, 11d, 13a, 13b, 13c, 13d, 21a, 21b) gegenüberliegt.

9. Das System (10, 20) nach einem der Ansprüche 1 bis 8, wobei zumindest eine, vorzugsweise jede, der mehreren Lamellen (12a, 12b, 12c, 22a, 22b) gekrümmt ausgebildet ist und eine Lamellenbogenlänge aufweist.

10. Das System (10, 20) nach einem der Ansprüche 4 bis 9,
wobei die Lamellenbogenlänge nach Anspruch 9 von dem Neigungswinkel nach einem der Ansprüche 4 bis 9 und/oder dem Lamellenkrümmungsradius nach einem der Ansprüche 7 bis 9 abhängt.

11. Das System (10, 20) nach einem der Ansprüche 4 bis 10,

wobei die Lamellenbogenlänge nach Anspruch 9 oder 10 gemäß der folgenden Formel bestimmt wird:

$$\frac{2\pi(\theta+10)}{360} \times ROC \ ,$$

wobei $\theta$ den Neigungswinkel nach einem der Ansprüche 4 bis 10 bezeichnet, und
wobei $ROC$ den Krümmungsradius der Lamelle nach einem der Ansprüche 7 bis 10 bezeichnet.

12. Das System (10, 20) nach einem der Ansprüche 1 bis 11,
wobei zwischen 30 und 70 Prozent, vorzugsweise zwischen 33 und 67 Prozent, noch bevorzugter zwischen 40 und 60 Prozent, am meisten bevorzugt die Hälfte, der mehreren Lamellen (12a, 12b, 12c, 22a, 22b) innerhalb eines oberen Volumens angeordnet ist, welches eine vordere Fläche des entsprechenden Photovoltaikmoduls (11a, 11b, 11c, 11d, 13a, 13b, 13c, 13d, 21a, 21b) aufweist, nicht aber eine der vorderen Fläche des entsprechenden Photovoltaikmoduls (11b, 11c, 11d, 13a, 13b, 13c, 13d, 21a, 21b) gegenüberliegende hintere Fläche.

13. Das System (10, 20) nach einem der Ansprüche 1 bis 12,
wobei zwischen 30 und 70 Prozent, vorzugsweise zwischen 33 und 67 Prozent, noch bevorzugter zwischen 40 und 60 Prozent, am meisten bevorzugt die Hälfte, der mehreren Lamellen (12a, 12b, 12c, 22a, 22b) innerhalb eines unteren Volumens angeordnet ist, welches eine einer vorderen Fläche des entsprechenden Photovoltaikmoduls (11a, 11b, 11c, 11d, 13a, 13b, 13c, 13d, 21a, 21b) gegenüberliegende hintere Fläche aufweist, nicht aber die vordere Fläche des entsprechenden Photovoltaikmoduls (11a, 11b, 11c, 11d, 13a, 13b, 13c, 13d, 21a, 21b).

14. Ein Verfahren zum Anordnen von zumindest zwei Photovoltaikmodulen (11a, 11b, 11c, 11d, 13a, 13b, 13c, 13d, 21a, 21b), von denen jedes eine jeweilige Modulfläche aufweist, welche im Wesentlichen senkrecht zur Dicke des entsprechenden Photovoltaikmoduls (11a, 11b, 11c, 11d, 13a, 13b, 13c, 13d, 21a, 21b) ist, jede der zumindest zwei Modulflächen zumindest eine von zwei ersten Seiten aufweist, die im Wesentlichen senkrecht zur Dicke des entsprechenden Photovoltaikmoduls (11a, 11b, 11c, 11d, 13a, 13b, 13c, 13d, 21a, 21b) sind, und/oder zwei zweiten Seiten, die im Wesentlichen senkrecht zur Dicke des entsprechenden Photovoltaikmoduls (11a, 11b, 11c, 11d, 13a, 13b, 13c, 13d, 21a, 21b) sind, wobei das Verfahren die folgenden Schritte aufweist:

im Wesentlichen paralleles Anordnen (100) der zumindest zwei Modulflächen,
Versetzen (101) der zumindest zwei Modulflächen gegeneinander in einer Erstreckungsrichtung (14) der zumindest zwei Photovoltaikmodule (11a, 11b, 11c, 11d, 13a, 13b, 13c, 13d, 21a, 21b),
versetztes oder alternierendes Anordnen (102) der zumindest zwei Modulflächen in Bezug auf eine Erstreckungsebene (15) in Erstreckungsrichtung (14) der zumindest zwei Photovoltaikmodule (11a, 11b, 11c, 11d, 13a, 13b, 13c, 13d, 21a, 21b), und
Anordnen (103) mehrerer Lamellen (12b, 12c, 22a, 22b) in einem Bereich zumindest einer der beiden ersten Seiten und/oder der beiden zweiten Seiten der jeweiligen Modulfläche des entsprechenden Photovoltaikmoduls (11a, 11b, 11c, 11d, 13a, 13b, 13c, 13d, 21a, 21b).

15. Das Verfahren nach Anspruch 14,
wobei das Verfahren ferner den Schritt des Konfigurierens von zumindest einer, vorzugsweise jeder, der mehreren Lamellen (12a, 12b, 12c, 22a, 22b) aufweist, um Wind einzufangen und/oder Wind zu einer zu der jeweiligen Modulfläche im Wesentlichen parallelen vorderen Fläche zu leiten und/oder zu einer der vorderen Fläche des entsprechenden Photovoltaikmoduls (11a, 11b, 11c, 11d, 13a, 13b, 13c, 13d, 21a, 21b) gegenüberliegenden hinteren Fläche und/oder zu den zumindest zwei Photovoltaikmodulen (11a, 11b, 11c, 11d, 13a, 13b, 13c, 13d, 21a, 21b).

## Revendications

1. Un système (10, 20) comportant :

au moins deux modules photovoltaïques (11a, 11b, 11c, 11d, 13a, 13b, 13c, 13d, 21a, 21b), chacun comportant une zone de module respective étant sensiblement perpendiculaire à l'épaisseur du module photovoltaïque (11a, 11b, 11c, 11d, 13a, 13b, 13c, 13d, 21a, 21b) correspondant, chacune des au moins deux zones de module comportant au moins un élément parmi deux premiers côtés étant sensiblement perpendiculaires à l'épaisseur du module photovoltaïque (11a, 11b, 11c, 11d, 13a, 13b, 13c, 13d, 21a, 21b) correspondant et/ou deux seconds côtés étant sensiblement perpendiculaires à l'épaisseur du module photovoltaïque (11a, 11b, 11c, 11d, 13a, 13b, 13c, 13d, 21a, 21b) correspondant,

dans lequel les au moins deux zones de module sont agencées d'une manière sensiblement parallèle l'une par rapport à l'autre et sont décalées l'une par rapport à l'autre dans une direction d'extension (14) du système (10, 20),

dans lequel les au moins deux zones de module sont agencées d'une manière décalée ou alternée par rapport à un plan d'extension (15) dans la direction d'extension (14) du système (10, 20),

**caractérisé en ce que**

le système (10, 20) et/ou au moins un des au moins deux modules photovoltaïques (11a, 11b, 11c, 11d, 13a, 13b, 13c, 13d, 21a, 21b) comporte des ailettes multiples (12a, 12b, 12c, 22a, 22b) étant agencées dans une région d'au moins un des deux premiers côtés et/ou des deux seconds côtés de la zone de module respective du module photovoltaïque (11a, 11b, 11c, 11d, 13a, 13b, 13c, 13d, 21a, 21b) correspondant.

2. Le système (10, 20) selon la revendication 1, dans lequel au moins une, de préférence chacune, des multiples ailettes (12a, 12b, 12c, 22a, 22b) est configurée pour piéger le vent et/ou pour guider le vent jusqu'à une surface avant étant sensiblement parallèle à la zone de module respective et/ou une surface arrière étant opposée à la surface avant du module photovoltaïque (11a, 11b, 11c, 11d, 13a, 13b, 13c, 13d, 21a, 21b) correspondant et/ou jusqu'au système (10, 20).

3. Le système (10, 20) selon la revendication 1 ou 2, dans lequel la distance respective d'au moins une, en particulier de chacune, des au moins deux zones de module par rapport au plan d'extension (15) est un multiple, de manière préférée le triple, de manière plus préférée le double, de manière la plus préférée entre 0,9 et 1,1 fois, de l'épaisseur du module photovoltaïque (11a, 11b, 11c, 11d, 13a, 13b, 13c, 13d, 21a, 21b) correspondant.

4. Le système (10, 20) selon l'une quelconque des revendications 1 à 3, dans lequel au moins une, de préférence chacune, des au moins deux zones de module est agencée à un angle d'inclinaison par rapport au plan d'extension (15) et/ou un plan horizontal.

5. Le système (10, 20) selon la revendication 4, dans lequel l'angle d'inclinaison est compris entre 5 et 40 degrés, de préférence entre 10 et 35 degrés.

6. Le système (10, 20) selon l'une quelconque des revendications 1 à 5,

dans lequel un espace entre chaque paire des moins deux zones de module dans la direction d'extension (14) est compris entre 0,045 et 0,055 fois, de préférence égal à 0,05 fois, une dimension d'un des deux premiers côtés ou des deux seconds côtés d'une des zones de module de la paire respective.

7. Le système (10, 20) selon l'une quelconque des revendications 1 à 6, dans lequel au moins une, de préférence chacune, des multiples ailettes (12a, 12b, 12c, 22a, 22b) est configurée d'une manière incurvée et présente un rayon de courbure d'ailette.

8. Le système (10, 20) selon la revendication 7,

dans lequel le rayon de courbure d'ailette est compris entre 4 et 6 centimètres, de manière préférée entre 4,5 et 5,5 centimètres, de manière plus préférée entre 4,8 et 5,2 centimètres, de manière la plus préférée de 5 centimètres, en particulier pour le cas où les ailettes respectives parmi les multiples ailettes (12a, 12b, 12c, 22a, 22b) sont situées à l'intérieur d'un volume inférieur comportant une surface arrière étant opposée à une surface avant du module photovoltaïque (11a, 11b, 11c, 11d, 13a, 13b, 13c, 13d, 21a, 21b) correspondant mais pas la surface avant du module photovoltaïque (11a, 11b, 11c, 11d, 13a, 13b, 13c, 13d, 21a, 21b) correspondant, et/ou

dans lequel le rayon de courbure d'ailette est compris entre 16 et 22 centimètres, de manière préférée entre 18 et 20 centimètres, en particulier pour le cas où les ailettes respectives parmi les ailettes multiples (12a, 12b, 12c, 22a, 22b) sont situées à l'intérieur d'un volume supérieur comportant une surface avant du module photovoltaïque (11a, 11b, 11c, 11d, 13a, 13b, 13c, 13d, 21a, 21b) correspondant mais pas une surface arrière étant opposée à la surface avant du module photovoltaïque (11a, 11b, 11c, 11d, 13a, 13b, 13c, 13d, 21a, 21b) correspondant.

9. Le système (10, 20) selon l'une quelconque des revendications 1 à 8, dans lequel au moins une, de préférence chacune, des multiples ailettes (12a, 12b, 12c, 22a, 22b) est configurée d'une manière incurvée et présente une longueur d'arc d'ailette.

10. Le système (10, 20) selon l'une quelconque des revendications 4 à 9, dans lequel la longueur d'arc d'ailette selon la revendication 9 dépend de l'angle d'inclinaison selon l'une quelconque des revendications 4 à 9 et/ou du rayon de courbure d'ailette selon l'une quelconque des revendications 7 à 9.

11. Le système (10, 20) selon l'une quelconque des revendications 4 à 10,

dans lequel la longueur d'arc d'ailette selon la revendication 9 ou 10 est déterminée d'après la formule suivante :

$$\frac{2\pi(\theta + 10)}{360} \times ROC \ ,$$

dans laquelle θ représente l'angle d'inclinaison selon l'une quelconque des revendications 4 à 10, et

dans laquelle ROC représente le rayon de courbure d'ailette selon l'une quelconque des revendications 7 à 10.

12. Le système (10, 20) selon l'une quelconque des revendications 1 à 11,
dans lequel entre 30 et 70 pour-cent, de manière préférée entre 33 et 67 pour-cent, de manière plus préférée entre 40 et 60 pour-cent, de manière la plus préférée la moitié, des multiples ailettes (12a, 12b, 12c, 22a, 22b) est situé à l'intérieur d'un volume supérieur comportant une surface avant du module photovoltaïque (11a, 11b, 11c, 11d, 13a, 13b, 13c, 13d, 21a, 21b) correspondant mais pas une surface arrière étant opposée à la surface avant du module photovoltaïque (11a, 11b, 11c, 11d, 13a, 13b, 13c, 13d, 21a, 21b) correspondant.

13. Le système (10, 20) selon l'une quelconque des revendications 1 à 12,
dans lequel entre 30 et 70 pour-cent, de manière préférée entre 33 et 67 pour-cent, de manière plus préférée entre 40 et 60 pour-cent, de manière la plus préférée la moitié, des multiples ailettes (12a, 12b, 12c, 22a, 22b) est situé à l'intérieur d'un volume inférieur comportant une surface arrière étant opposée à une surface avant du module photovoltaïque (11a, 11b, 11c, 11d, 13a, 13b, 13c, 13d, 21a, 21b) correspondant mais pas la surface avant du module photovoltaïque (11a, 11b, 11c, 11d, 13a, 13b, 13c, 13d, 21a, 21b) correspondant.

14. Un procédé pour agencer au moins deux modules photovoltaïques (11a, 11b, 11c, 11d, 13a, 13b, 13c, 13d, 21a, 21b), comportant chacun une zone de module respective étant sensiblement perpendiculaire à l'épaisseur du module photovoltaïque (11a, 11b, 11c, 11d, 13a, 13b, 13c, 13d, 21a, 21b) correspondant, chacune des au moins deux zones de module comportant au moins un élément parmi deux premiers côtés étant sensiblement perpendiculaires à l'épaisseur du module photovoltaïque (11a, 11b, 11c, 11d, 13a, 13b, 13c, 13d, 21a, 21b) correspondant et/ou deux seconds côtés étant sensiblement perpendiculaires à l'épaisseur du module photovoltaïque (11a, 11b, 11c, 11d, 13a, 13b, 13c, 13d, 21a, 21b) correspondant, le procédé comportant les étapes consistant à :

agencer (100) les au moins deux zones de module d'une manière sensiblement parallèle l'une par rapport l'autre,
décaler (101) les au moins deux zones de module l'une par rapport à l'autre dans une direction d'extension (14) des au moins deux modules photovoltaïques (11a, 11b, 11c, 11d, 13a, 13b, 13c, 13d, 21a, 21b),
agencer (102) les au moins deux zones de module d'une manière décalée ou alternée par rapport à un plan d'extension (15) dans la direction d'extension (14) des au moins deux modules photovoltaïques (11a, 11b, 11c, 11d, 13a, 13b, 13c, 13d, 21a, 21b), et
agencer (103) de multiples ailettes (12a, 12b, 12c, 22a, 22b) dans une région d'au moins un élément parmi les deux premiers côtés et/ou les deux seconds côtés de la zone de module respective du module photovoltaïque (11a, 11b, 11c, 11d, 13a, 13b, 13c, 13d, 21a, 21b) correspondant.

15. Le procédé selon la revendication 14,
dans lequel le procédé comporte en outre l'étape consistant à configurer au moins une, de préférence chacune, des multiples ailettes (12a, 12b, 12c, 22a, 22b) pour piéger le vent et/ou pour guider le vent jusqu'à une surface avant étant sensiblement parallèle à la zone de module respective et/ou une surface arrière étant opposée à la surface avant du module photovoltaïque (11a, 11b, 11c, 11d, 13a, 13b, 13c, 13d, 21a, 21b) correspondant et/ou jusqu'aux au moins deux modules photovoltaïques (11a, 11b, 11c, 11d, 13a, 13b, 13c, 13d, 21a, 21b).

Fig. 1A

Fig. 1B

Fig. 2

30

Fig. 3

Surface: Velocity magnitude (m/s)

**Fig. 4A**

Surface: Velocity magnitude (m/s)

**Fig. 4B**

Fig. 5A

Fig. 5B

EP 4 199 120 B1

Fig. 6A

Fig. 6B

Fig. 7A

Fig. 7B

| Wind | Conventional modules | | | | | | GVS modules | | | | | | ΔTave | ΔTmax |
|------|-------|-------|-------|-------|-------|-------|-------|-------|-------|-------|-------|-------|-------|-------|
| dir. | T1 | T2 | T3 | T4 | Tave | Tmax | T1 | T2 | T3 | T4 | Tave | Tmax | | |
| 0 | 352.3 | 354.2 | 355.4 | 350.8 | 353.2 | 355.4 | 350.9 | 353.9 | 353.7 | 350.2 | 352.2 | 353.9 | -1.0 | -1.5 |
| 45 | 341.4 | 352.1 | 358.8 | 360.3 | 353.2 | 360.3 | 341.9 | 353.9 | 357.6 | 351.3 | 351.2 | 357.6 | -2.0 | -2.8 |
| 90 | 346.4 | 356.9 | 364.2 | 367.2 | 358.7 | 367.2 | 345.2 | 353.4 | 358.5 | 361.6 | 354.7 | 361.6 | -4.0 | -5.6 |
| 135 | 344.0 | 348.2 | 354.8 | 359.8 | 351.7 | 359.8 | 340.6 | 346.8 | 346.8 | 351.2 | 346.4 | 351.2 | -5.3 | -8.6 |
| 180 | 355.9 | 352.4 | 352.0 | 354.6 | 353.7 | 355.9 | 345.2 | 342.7 | 345.5 | 341.2 | 343.6 | 345.5 | -10.1 | -10.4 |
| | | | | | | | | | | | | | -4.5 | -5.8 |

Fig. 8

Arrange at least two module areas, each being comprised by a respective photovoltaic module and being substantially perpendicular to the thickness of the corresponding photovoltaic module, each of the at least two module areas comprising at least one of two first sides being substantially perpendicular to the thickness of the corresponding photovoltaic module and/or two second sides being substantially perpendicular to the thickness of the corresponding photovoltaic module, in a substantially parallel manner with respect to each other

100

Shift the at least two module areas with respect to each other in an extension direction of the at least two photovoltaic modules

101

Arrange the at least two module areas in a staggering or alternating or ascending or descending manner with respect to an extension plane in the extension direction of the at least two photovoltaic modules

102

Arrange multiple vanes in a region of at least one of the two first sides and/or the two second sides of the respective module area of the corresponding photovoltaic module

103

# Fig. 9

**EP 4 199 120 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013093377 A
- US 2010126554 A1
- US 2014299178 A1
- US 6061978 A
- EP 2362161 B1
- US 2005263181 A1